# EUROPEAN PATENT APPLICATION

(11) **EP 4 572 539 A1**
(43) Date of publication of application: **18.06.2025**
(21) Application number: 23215551.5
(22) Date of filing: 11.12.2023
(51) Int. Cl.: H05K 1/18, H05K 3/00, H05K 3/04, H05K 3/46

(54) **COMPONENT CARRIER AND METHOD FOR MANUFACTURING A COMPONENT CARRIER**

(71) Applicant: AT & S Austria Technologie & Systemtechnik Aktiengesellschaft, 8700 Leoben-Hinterberg (AT)
(72) Inventor: SCHLICK, Daniel, 8733 St. Marein-Feistritz (AT); ZIPPER, Wolfgang, 8330 Feldbach (AT); TRISCHLER, Heinrich, 8063 Eggersdorf (AT); ZOTTER, Markus, 8383 Welten (AT); SCHLAFFER, Erich, 8642 St. Lorenzen (AT)
(74) Representative: Burger, Hannes

(57) **Abstract**

The invention relates to a component carrier (1) comprising a stack (2) of a plurality of layers (12) forming at least one electrically conductive layer structure (3) and at least one electrically insulating layer structure (4), said stack (2) comprising a - preferably conically shaped - cavity (5), wherein the cavity (5) extends - in the direction (D) perpendicular to the planes (P) in which the layers (12) extend - through at least two layers (12) of the plurality of layers, said cavity (5) being delimited by a side wall (6), said side wall (6) being inclined with respect to the direction (D) perpendicular to the planes (P) of the layers (12), wherein at least one recess (7) is provided in the side wall (6) of said cavity (5), said recess (7) locally disrupting the side wall extension and partially extending in the stack (2) along the planar extension of the stack (2).

## Description

The invention relates to a component carrier comprising a stack of a plurality of layers forming at least one electrically conductive layer structure and at least one electrically insulating layer structure, said stack comprising a cavity. The invention also relates to a component carrier assembly and to a method for manufacturing a component carrier.

JP2020145395A discloses a printed circuit board that realizes a large difference in height between a soft or flexible substrate portion and a hard or rigid substrate portion. The rigid substrate portions are connected to the flexible substrate portion and formed thicker than the flexible substrate portion. The manufacturing process of such a printed circuit board includes a step of removing the hard laminated portion to a second stopper layer by a first processing step and then performing a second processing step to remove the hard laminated portion to a first stopper layer to expose the soft laminated portion. The first stopper layer and the second stopper layer are metal layers. The first processing step and the second processing step include laser processing.

KR20130004650A discloses a method for manufacturing a cavity for a built-in substrate. An insulation layer with reinforced fibers is cut, and a space is formed. Copper foils are laminated on the upper and lower parts of the insulation layer with the reinforced fibers. A laminate molding process is performed by heating and pressurizing the copper foils. A resin insulation part is formed by charging the space with resins from the insulation layer. The cavity is formed by performing a laser processing step.

KR20020009794A discloses a method for manufacturing a multi-layer PCB comprising the forming of a blind via hole. The method comprises a step of forming a first printed circuit pattern onto a copper clad laminate through a photo-etching process and a step of forming a second printed circuit pattern, through a photo-etching process, onto the substrate. In a further step a blind via hole is formed by removing resin coated copper by radiating a YAG laser onto a predetermined portion of the substrate. In further steps a copper portion is removed through a photo-etching process, and a resin portion is removed by radiating CO2 laser.

With the prior art processes, only a limited depth can be realized as the laser beam energy decreases per increasing depth. In the case of deep cavities, the following disadvantages occur: high surface roughness (of the cavities' side walls) and low accuracy in depth control and width. According to an application, cavities (such as sealed cavities fully shielded by copper coated sidewalls) may act as waveguides. Inside such channels RF signals can propagate. Such channels are frequency dependent, meaning, the lower the frequency, the larger the waveguide needs to be (λ/2). In order to implement such waveguides for RF boards (e.g. operating at around 70 GHz), processes needs to be adjusted in order to form deep cavities. For such implementation purpose sidewall roughness of the cavity walls are crucial.

It has been the object of the present invention to overcome the disadvantages of the prior art and to provide a component carrier and method for manufacturing a component carrier by means of which a high surface quality and high accuracy in depth control and width are achieved. Component carrier shall be producible in a reliable and cost-effective manner.

This object is achieved by a component carrier comprising a stack of a plurality of layers forming at least one electrically conductive layer structure and at least one electrically insulating layer structure, said stack comprising a - preferably conically shaped - cavity, wherein the cavity extends - in the direction perpendicular to the planes in which the layers extend - through at least two layers of the plurality of layers, said cavity being delimited by a side wall, said side wall being inclined with respect to the direction perpendicular to the planes of the layers, preferably by an inclination angle between 0,5° and 50°, preferably between 0,5° and 30°, more preferred between 1° and 15°, wherein at least one recess is provided in the side wall of said cavity, said recess locally disrupting the side wall extension and partially extending in the stack along the planar extension of the stack.

The component carrier according to the invention is a direct result of a manufacturing method, that may use a laser beam for removing material to form the cavity. Laser drilling is the preferred process of creating the cavity, by focussing a laser beam on the material to be removed. One of the objects of the invention is to form deep and wide cavities. In that case the laser beam is moved around the circumference of the cavity to form the side walls. The invention allows to use a laser beam that has a pronounced focus, i.e. the cross-section of the beam decreases in direction towards the intended cut. The extent of inclination of the side wall may be adjusted by the geometry of the laser beam and/or the transversal movement of the laser beam when getting deeper into the stack. Additionally or alternatively, the extent of inclination of the side wall may be adjusted by the emitted intensity of the laser beam and/or the pulse rate of the laser beam.

The inclination of the side wall with respect to the direction perpendicular to the planes of the layers may also have advantageous effects on several applications. One of them is a more efficient RF coupling and/or decoupling in the case the cavity is used a RF waveguide. Also, in the case of cooling or heating channels the inclined shape or run of the side walls may be advantageous, in particular, to optimize the stream of the cooling or heating medium.

The recess may originate from a release layer, that has been provided within the starting stack. "Locally disrupting the side wall extension" means that the recess locally interrupts the - preferably smooth - extension of the side wall. The recess may be in the form of a groove or an indentation (or "bay"). The recess may e.g. run circumferentially within the side wall of the cavity. There may be also two or more recesses formed in the side wall of the cavity, preferably each recess extending on a different height level of the stack.

When forming the cavity, release layers may be used to separate individual processing (material removal) steps. The material of the release layer then may be removed to an extent, such that a recess is formed within the side wall of the cavity. In combination with the inclination, the recess does not only allow a reliable manufacturing method, but maybe also used for other purposes, such as a mechanical fixing structure for an electrically conductive layer that forms a lining of the cavity. Moreover, the recess may be used for positioning or fixing other components, including (ring-shaped) structures, electronic components, etc.

In the context of the present application, the term "component carrier" may particularly denote any support structure which is capable of accommodating one or more components thereon and/or therein for providing mechanical support and/or electrical connectivity. In other words, a component carrier may be configured as a mechanical and/or electronic carrier for components. In particular, a component carrier may be one of a printed circuit board, an organic interposer, and an IC (integrated circuit) substrate. A component carrier may also be a hybrid board combining different ones of the above mentioned types of component carriers.

In the context of the present application, the term "stack" may particularly denote an arrangement of multiple planar layer structures which are mounted in parallel on top of one another.

In the context of the present application, the term "layer structure" may particularly denote a continuous layer, a patterned layer or a plurality of non-consecutive islands within a common plane.

In the context of the present application, the term "main surface" of a body may particularly denote one of two largest opposing surfaces of the body. The main surfaces may be connected by circumferential side walls. The thickness of a body, such as a stack, may be defined by the distance between the two opposing main surfaces.

In an embodiment, the component carrier is configured as one of the group consisting of a printed circuit board, a substrate (in particular an IC substrate), and an interposer.

In the context of the present application, the term "printed circuit board" (PCB) may particularly denote a plate-shaped component carrier which is formed by laminating several electrically conductive layer structures with several electrically insulating layer structures, for instance by applying pressure and/or by the supply of thermal energy. As preferred materials for PCB technology, the electrically conductive layer structures are made of copper, whereas the electrically insulating layer structures may comprise resin and/or glass fibers, so-called prepreg or FR4 material. The various electrically conductive layer structures may be connected to one another in a desired way by forming holes through the laminate, for instance by laser drilling or mechanical drilling, and by partially or fully filling them with electrically conductive material (in particular copper), thereby forming vias or any other through-hole connections. The filled hole either connects the whole stack, (through-hole connections extending through several layers or the entire stack), or the filled hole connects at least two electrically conductive layers, called via. Similarly, optical interconnections can be formed through individual layers of the stack in order to receive an electro-optical circuit board (EOCB). Apart from one or more components which may be embedded in a printed circuit board, a printed circuit board is usually configured for accommodating one or more components on one or both opposing surfaces of the plate-shaped printed circuit board. They may be connected to the respective main surface by soldering. A dielectric part of a PCB may be composed of resin with reinforcing fibers (such as glass fibers).

In the context of the present application, the term "substrate" may particularly denote a small component carrier. A substrate may be a, in relation to a PCB, comparably small component carrier onto which one or more components may be mounted and that may act as a connection medium between one or more chip(s) and a further PCB. For instance, a substrate may have substantially the same size as a component (in particular an electronic component) to be mounted thereon (for instance in case of a Chip Scale Package (CSP)). More specifically, a substrate can be understood as a carrier for electrical connections or electrical networks as well as component carrier comparable to a printed circuit board (PCB), however with a considerably higher density of laterally and/or vertically arranged connections. Lateral connections are for example conductive paths, whereas vertical connections may be for example drill holes. These lateral and/or vertical connections are arranged within the substrate and can be used to provide electrical, thermal and/or mechanical connections of housed components or unhoused components (such as bare dies), particularly of IC chips, with a printed circuit board or intermediate printed circuit board. Thus, the term "substrate" also includes "IC substrates". A dielectric part of a substrate may be composed of resin with reinforcing particles (such as reinforcing spheres, in particular glass spheres).

The substrate or interposer may comprise or consist of at least a layer of glass, silicon (Si) and/or a photoimageable or dry-etchable organic material like epoxy-based build-up material (such as epoxy-based build-up film) or polymer compounds (which may or may not include photo- and/or thermosensitive molecules) like polyimide or polybenzoxazole.

In an embodiment, the at least one electrically insulating layer structure comprises at least one of the group consisting of a resin or a polymer, such as epoxy resin, cyanate ester resin, benzocyclobutene resin, bismaleimidetriazine resin, polyphenylene derivate (for example based on polyphenylenether, PPE), polyimide (PI), polyamide (PA), liquid crystal polymer (LCP), polytetrafluoroethylene (PTFE) and/or a combination thereof. Reinforcing structures such as webs, fibers, spheres or other kinds of filler particles, for example made of glass (multilayer glass) in order to form a composite, could be used as well. A semi-cured resin in combination with a reinforcing agent, for example fibers impregnated with the above-mentioned resins is called prepreg. These prepregs are often named after their properties for example FR4 or FR5, which describe their flame retardant properties. Although prepreg particularly FR4 are usually preferred for rigid PCBs, other materials, in particular epoxy-based build-up materials (such as build-up films) or photoimageable dielectric materials, may be used as well. For high frequency applications, high-frequency materials such as polytetrafluoroethylene, liquid crystal polymer and/or cyanate ester resins, may be preferred. Besides these polymers, low temperature cofired ceramics (LTCC) or other low, very low or ultra-low DK materials may be applied in the component carrier as electrically insulating structures.

In an embodiment, the at least one electrically conductive layer structure comprises at least one of the group consisting of copper, aluminum, nickel, silver, gold, palladium, tungsten and magnesium. Although copper is usually preferred, other materials or coated versions thereof are possible as well, in particular coated with supra-conductive material or conductive polymers, such as graphene or poly(3,4-ethylenedioxythiophene) (PEDOT), respectively.

In an embodiment, the component carrier is a laminate-type component carrier. In such an embodiment, the component carrier is a compound of multiple layer structures which are stacked and connected together by applying a pressing force and/or heat.

After processing interior layer structures of the component carrier, it is possible to cover (in particular by lamination) one or both opposing main surfaces of the processed layer structures symmetrically or asymmetrically with one or more further electrically insulating layer structures and/or electrically conductive layer structures. In other words, a build-up may be continued until a desired number of layers is obtained.

After having completed formation of a stack of electrically insulating layer structures and electrically conductive layer structures, it is possible to proceed with a surface treatment of the obtained layers structures or component carrier.

In particular, an electrically insulating solder resist may be applied to one or both opposing main surfaces of the layer stack or component carrier in terms of surface treatment. For instance, it is possible to form such a solder resist on an entire main surface and to subsequently pattern the layer of solder resist so as to expose one or more electrically conductive surface portions which shall be used for electrically coupling the component carrier to an electronic periphery. The surface portions of the component carrier remaining covered with solder resist may be efficiently protected against oxidation or corrosion, in particular surface portions containing copper.

It is also possible to apply a surface finish selectively to exposed electrically conductive surface portions of the component carrier in terms of surface treatment. Such a surface finish may be an electrically conductive cover material on exposed electrically conductive layer structures (such as pads, conductive tracks, etc., in particular comprising or consisting of copper) on a surface of a component carrier. If such exposed electrically conductive layer structures are left unprotected, then the exposed electrically conductive component carrier material (in particular copper) might oxidize, making the component carrier less reliable. A surface finish may then be formed for instance as an interface between a surface mounted component and the component carrier. The surface finish has the function to protect the exposed electrically conductive layer structures (in particular copper circuitry) and enable a joining process with one or more components, for instance by soldering. Examples for appropriate materials for a surface finish are Organic Solderability Preservative (OSP), Electroless Nickel Immersion Gold (ENIG), Electroless Nickel Immersion Palladium Immersion Gold (ENIPIG), gold (in particular hard gold), chemical tin, nickel-gold, nickel-palladium, etc.

Preferably, the component carrier assembly is a printed circuit board (PCB) and/or a substrate (such as an IC substrate) and/or an interposer.

Preferably, the electrically conductive layer structure is and/or comprises a trace, such as horizontal trace and/or vertical trace (via), and/or a combination of (patterned) traces and/or a pad and/or a land and/or a connecting lip.

According to a preferred embodiment, the cavity has - in the direction perpendicular to the planes in which the layers extend - an extension of at least 200 µm, preferably at least 400 µm, more preferred at least 600 µm. This may bring the advantage of creating a big cavity regarding the direction perpendicular to the planes in which the layers extend in an efficient and precise manner using the described method. Additionally, the method may give the advantage of adapting the depth of the cavity very easily.

According to a preferred embodiment, the cavity has - in a direction parallel to the planes in which the layers extend - a width of at least 300 µm, preferably at least 1000 µm, more preferred at least 2000 µm. This may bring the advantage of creating a long cavity in direction parallel to the planes in which the layers extend and/or creating a cavity having a big area in the aforementioned direction using the described method. Additionally, the cavity may provide the accuracy which is required for radio frequency and/or high frequency applications.

According to a preferred embodiment, said recess has - in the direction perpendicular to the planes in which the layers extend - an extension between 2 µm and 350 µm, preferably between 5 µm and 250 µm, and/or wherein said recess runs circumferentially around the cavity and/or wherein said recess is arranged at a level that is distanced from the bottom of the cavity by 30% to 70%, preferably 40% to 60%, of the height of the cavity or is arranged in the region of the bottom of the cavity. This may bring the advantage of supplying an anchor-like structure, which improves the integrity of the stack. Said anchor-like structure can be easily and effectively made using the described method and may offer mechanical stability for an interaction with an electrically conductive layer structure and/or an electrically insulating layer structure.

According to a preferred embodiment, wherein said recess comprises residues of a material, preferably said material being different from the material(s) forming said side wall of the cavity, wherein preferably the residues of the material is free from filler material, in particular, reinforce material such as glass fiber. This may bring the advantage of a reliable formation of the recess, since the material of the recess have different chemical and/or physical properties. The involved method may be capable of dealing with material being different from the material(s) forming said side wall of the cavity in an easy way and may enable a precise placement of said material.

According to a preferred embodiment, said recess is at least partially filled with a material, preferably said material being different from one of the material(s) forming said side wall of the cavity. This may bring the advantage of imparting mechanical stability from the material forming said side wall of the cavity via the at least partially filled material. For example, an electrically conductive layer structure and/or an electrically insulating layer structure may indirectly adhere to the recess of the cavity via the filler material at least partially filling the recess.

According to a preferred embodiment, said recess is at least partially filled with an electrically conductive material, wherein preferably the side wall of the cavity is at least partially, preferably completely, covered by the electrically conductive material, preferably being monolithically merged with the conductive material within the recess. This may bring the advantage of guiding electromagnetic signal, for example high frequency and/or radio signals, with low losses through the cavity (having at least one recess).

Electrically conductive material may comprise or consist of one metal, for example copper or may comprise at least two layers of metal comprising copper, titanium, silver, tungsten, chromium, nickel, tin, or oxides or nitrides of the listed metals.

According to a preferred embodiment, said recess is at least partially filled with an electrically insulating material, wherein preferably said electrically insulating material is the same material that also covers at least partially, preferably completely, the side wall of the cavity. Preferably, the electrically insulating material (partially filling the recess) is free from epoxy resin and/or free from polyimide and/or free from material forming the at least one electrically insulating layer structure. This may bring the advantage of electrically decoupling/insulating the stack from the cavity, in particular inside the cavity, since the electrically insulating material has a high electrical resistance, for example higher than 1000 Ohm/cm.

According to a preferred embodiment, a recess of the at least one recess is located at the bottom extremity of the cavity. The use of the described method may enable an easy and sufficient way to position the recess in the cavity accordingly.

According to a preferred embodiment, an intermediate recess of the at least one recess is located at the side wall of the cavity between the bottom extremity of the cavity and the top extremity of the cavity. The use of the described method may enable an easy and sufficient way to position the recess in the cavity accordingly.

According to a preferred embodiment, the at least one recess - in the direction perpendicular to the planes in which the layers extend - is at least partially delimited by an electrically insulating layer structure. This fingerprint feature related from the method may bring the advantage of creating an electrically insulation at one side of the cavity.

According to a preferred embodiment, the side wall of the cavity is divided by said intermediate recess in two side wall portions. This may bring the advantage of defining the cavity (outlines) more precisely, since an involved two step formation of the cavity comprises a further alignment step, which enables the higher accuracy.

According to a preferred embodiment, the two side wall portions are each inclined with respect to the direction perpendicular to the planes of the layers, preferably by an inclination angle between 0,5° and 30°, preferably between 1° and 15°, wherein preferably the inclination angle α of the first of the two side wall portions is different to, preferably greater than, the inclination angle β of the second of the two side wall portions, wherein preferably the difference between the inclination angle α of the first of the two side wall portions and the inclination angle β of the second of the two side wall portions is between 0,5° and 10°. This fingerprint feature related from the manufacturing method may bring the advantage of having more design flexibility regarding the shape of the cavity. The related inclination of the sidewalls of the cavity may have an impact on the propagation of electrochemical signal and/or transmission of electrical signals.

According to a preferred embodiment, one of the two side wall portions is offset to the other of the two side wall portions in a direction parallel to the planes of the layers. This may bring the advantage of enlarging the surface area of the contour of the cavity and thus this may enhance the integrity of material, for example an electrically insulating layer structure or an electrically conductive layer structure, being in direct contact with the cavity, since higher surface area increases the (overall) adhesion. In a further embodiment the extent of the offset of opposing side walls (left and right side wall) is different (due to the twice alignment).

According to a preferred embodiment, at least two layers of the plurality of layers are interrupted by a recess-aperture and a ring-shaped element is provided in said recess-aperture, said ring-shaped element defining with its opening the cavity. The ring-shaped element may impart a higher mechanical stability to the cavity. Furthermore, the ring-shaped element may enable the formation of the recess-aperture using the described method in a precise way.

According to a preferred embodiment, the material of the ring-shaped element is different from the materials of the plurality of layers and/or has a homogeneous structure (such as same material, no fillers, etc.). This may bring the advantage of having an additional material for fine tuning the properties of the cavity, in particular its sidewalls, for example, stiffness or dielectric constant.

The object is also achieved by a component carrier assembly comprising a component carrier according to the invention or its embodiments, and at least one electronic component mounted to the component carrier, wherein preferably the electronic component is at least partially embedded within the component carrier, preferably within the cavity or adjacent to the cavity, wherein preferably the electronic component is a transducer for emitting and/or receiving radiation running through the cavity. This may bring the advantage that the related method may be feasible to create large, deep and/or broad cavities. Thus, components having a big volume may be reliably fully hosted, preferably embedded, inside the cavity.

The at least one component can be selected from a group consisting of an electrically nonconductive inlay, an electrically conductive inlay (such as a metal inlay, preferably comprising copper or aluminum), a heat transfer unit (for example a heat pipe), a light guiding element (for example an optical waveguide or a light conductor connection), an electronic component, or combinations thereof. An inlay can be for instance a metal block, with or without an insulating material coating (IMS-inlay), which could be either embedded or surface mounted for the purpose of facilitating heat dissipation. Suitable materials are defined according to their thermal conductivity, which should be at least 2 W/mK. Such materials are often based, but not limited to metals, metal-oxides and/or ceramics as for instance copper, aluminum oxide (Al2O3) or aluminum nitride (AlN). In order to increase the heat exchange capacity, other geometries with increased surface area are frequently used as well. Further-more, a component can be an active electronic component (having at least one p-n-junction implemented), a passive electronic component such as a resistor, an inductance, or capacitor, an electronic chip, a storage device (for instance a DRAM or another data memory), a filter, an integrated circuit (such as field-programmable gate array (FPGA), programmable array logic (PAL), generic array logic (GAL) and complex programmable logic devices (CPLDs)), a signal processing component, a power management component (such as a field-effect transistor (FET), metal-oxide-semiconductor field-effect transistor (MOSFET), complementary metal-oxide-semiconductor (CMOS), junction field-effect transistor (JFET), or insulated-gate field-effect transistor (IGFET), all based on semiconductor materials such as silicon carbide (SiC), gallium arsenide (GaAs), gallium nitride (GaN), gallium oxide (Ga2O3), indium gallium arsenide (InGaAs) and/or any other suitable inorganic compound), an optoelectronic interface element, a light emitting diode, a photocoupler, a voltage converter (for example a DC/DC converter or an AC/DC converter), a cryptographic component, a transmitter and/or receiver, an electromechanical transducer, a sensor, an actuator, a microelectromechanical system (MEMS), a microprocessor, a capacitor, a resistor, an inductance, a battery, a switch, a camera, an antenna, a logic chip, and an energy harvesting unit. However, other components may be embedded in the component carrier. For example, a magnetic element can be used as a component. Such a magnetic element may be a permanent magnetic element (such as a ferromagnetic element, an antiferromagnetic element, a multiferroic element or a ferrimagnetic element, for instance a ferrite core) or may be a paramagnetic element. However, the component may also be an IC substrate, an interposer or a further component carrier, for example in a board-in-board configuration. The component may be surface mounted on the component carrier and/or may be embedded in an interior thereof. Moreover, also other components, in particular those which generate and emit electromagnetic radiation and/or are sensitive with regard to electromagnetic radiation propagating from an environment, may be used as component.

Preferably, the electronic component is and/or comprises a chip and/or an integrated circuit (IC). The electronic component may be an active device, but may also be a passive device such as a capacitor, an inductor, or a resistor, or a combination thereof.

The object is also achieved by a method for manufacturing a component carrier, the method comprising the steps of:
(a) providing a stack of a plurality of layers forming at least one electrically conductive layer structure and at least one electrically insulating layer structure, said stack also comprising at least one release layer at least partially extending within the stack, and
(b) forming a cavity within said stack by removing material, preferably material of at least two layers of the plurality of layers or plugging material locally replacing layers of the plurality of layers, along a direction transverse, preferably perpendicular, to the planes in which the layers extend, up to the release layer, such that the cavity is delimited by a side wall, said side wall being inclined with respect to the direction perpendicular to the planes of the layers,
(c) removing at least a portion of the release layer, such that at least one recess is formed in the side wall of said cavity, said recess locally disrupting the side wall extension.

In a preferred embodiment at least a portion of the (original) release layer(s) is/are still present in the manufactured component carrier (i.e. in the final product), although a - preferably main
- portion of the release layer has been removed during the manufacturing process.

In an embodiment the release layer may be formed from a composite material having hydrophobic properties and optionally hydrophilic properties. The material of the release layer may change its properties when experiencing thermal treatment and/or UV/Vis irradiation exposure. It may be formed from a mixture of a release agent on the basis of at least a metal soap, a binding agent, and a solvent, wherein the metal of the metal soap may comprise Al, Mg, Ca, Na and/or Zn.

The properties of the release layer may be such, that it may be removed during a fluid treatment, for example by a solvent like water and/or organic material. Additionally or alternatively, it may be removable during a plasma treatment process.

According to a preferred embodiment, step (b) is performed by laser cutting along the contour of the resulting side wall.

According to a preferred embodiment, step (b) comprises the sub-steps of:
(b1) removing material of a first portion of the stack up to a first depth, wherein preferably the first depth is defined by an intermediate release layer, and
(b2) subsequent to step (b1) removing material of a second portion of the stack up to a second depth, wherein preferably the second depth is defined by a further release layer, preferably a bottom release layer. This may bring the advantage of defining the cavity (outlines) more precisely, since an involved two step formation of the cavity comprises a further alignment step, which enables the higher accuracy.

According to a preferred embodiment, sub-steps (b1) and (b2) are performed by laser cutting, wherein the geometry of the laser beam used for sub-step (b1) differs from the geometry of the laser beam used for sub-step (b1), wherein preferably the focus of the laser beam is - preferably automatically - adjusted between the sub-steps (b1) and (b2), wherein preferably the laser beam is focused on the top layer of the stack for sub-step (b1) and focused on the first depth for sub-step (b2). This may bring the advantage of adjusting the inclination angle α and the inclination angle β of the cavity's sidewall to desired values. The geometry of the cavity may have an influence on the electrical signal transmission and/or the electromagnetic wave propagation and can be easily adjusted according to actual needs.

The purpose of the invention is to form deep cavities to be used as signal transport channels, e.g. a waveguide. Waveguides can be seen as sealed cavities fully shielded by copper coated sidewalls. Inside such channels RF signals can propagate. Such channels are frequency dependent, meaning, the lower the frequency, the larger the waveguide needs to be (lambda/2). In order to implement such waveguides for RF boards operating at frequencies larger than 60 GHz and preferably lower that 200 GHz, conventional 2.5D^{®} processes need to be adjusted in order to form deep cavities. For such implementation purpose sidewall roughness of the cavity walls are crucial. The presented process-flow allows to manufacture waveguides with appropriate depth and sidewall roughness. Potential use of such cavities can be extended, e.g. if filled with a cooling medium in order to be used as thermal cooling channels.

The target of the invention is to form deep cavities. With the state of the art process, only a limited depth can be realized as the laser beam energy decreases per increasing depth. Therefor a split process route is proposed, including multiple release layers, where the first cavity will be cut with laser till the first release layer. After that the cut out (cap) will be removed. Then the layer below the cap will be used as the new registration/focus layer. A tool in laser programming can focus on a new height level to reduce the laser beam loss. With this new focus of the laser beam the second stage can be smooth laser cut. The second laser cut can be distinguished from the initial laser cut, for example by the recess, in the final product.

State of the art cavity forming will be done with laser, including 2.5D technology. For deep cavities, mechanical routing can be used with following disadvantages: high surface roughness, low accuracy in depth control & width.

The energy of the laser beam when drilling holes decreases with the cavity depth. By the presented method, it is possible to increase the energy-induced yield of the laser beam (newly adjusting the laser beam focus after an initial laser drilling step). In addition to this, by separating the drilling process in at least two steps (more than two are possible), allows to control the hole diameter at different heights, e.g. reducing the via diameter from the second drill-step.

The ability to form deep laser vias with varying diameter and most importantly drilling is possible with an optimized energy balance (footprint reduction).

The reliable use of the drilled holes as waveguides must ensure complete material removal from the drilled hole which will be removed as a complete structure.

According to a preferred embodiment, step (c) is performed by at least partially removing material of a release layer with a solvent. This may create the recess which is at least partially filled with an electrically insulating material. This may bring the advantage of electrically decoupling/insulating the stack from the cavity, in particular inside the cavity, since the electrically insulating material has a high electrical resistance, for example higher than 1000 Ohm/cm.

To provide better understanding of the invention, the invention is explained in more detail with the aid of the following figures.

The following is shown in a strongly simplified, schematic representation:
- Fig. 1: an embodiment of a component carrier;
- Fig. 2: a further embodiment of a component carrier having an offset between side wall portions;
- Fig. 3 to 6: an embodiment of a method for manufacturing a component carrier;
- Fig. 7: an embodiment of a component carrier in the process of being manufactured;
- Fig. 8: a further embodiment of a component carrier having electrically conductive material in the recess and on the side wall of the cavity;
- Fig. 9: a further embodiment of a component carrier.

As an introduction, it should be noted that in the embodiments described in different ways, identical parts or method steps are indicated with identical reference numbers or identical component designations; at the same time, the disclosures contained in the entire description may be analogously applied to identical parts with identical reference numbers or identical component designations. Moreover, the position indications chosen in the description, such as at the top, at the bottom, laterally, etc. refer to the figure which is directly represented and described; and if a position changes, said position indications are to be applied analogously to the new position.

The embodiments show possible variants; however, it should be noted at this point that the invention is not limited to the variants specifically shown; rather, various combinations of the individual variants are possible as well, and, due to the technical information provided by the present invention, this variation possibility is subject to the skills of the person skilled in the art who works in this technical field.

The scope of protection is determined by the claims. However, the description and the drawings are to be used for construing the claims. Individual features or feature combinations from the different embodiments that are shown and described may per se constitute independent solutions according to the invention. The object underlying the independent solutions according to the invention may be gathered from the description.

Any indications of value ranges in the present description are to be understood as including any and all subranges thereof; for example, the indication 1 to 10 is to be understood as including all subranges, starting out from the lower boundary 1 to the upper boundary 10; i.e. all subranges start with a lower boundary of 1 or greater and stop at an upper boundary of 10 or less, e.g. 1 to 1.7 or 3.2 to 8.1 or 5.5 to 10.

For the sake of good order, it should finally be noted that, for better understanding, some of the facts shown in the figures have been represented unscaled and/or enlarged and/or in reduced size.

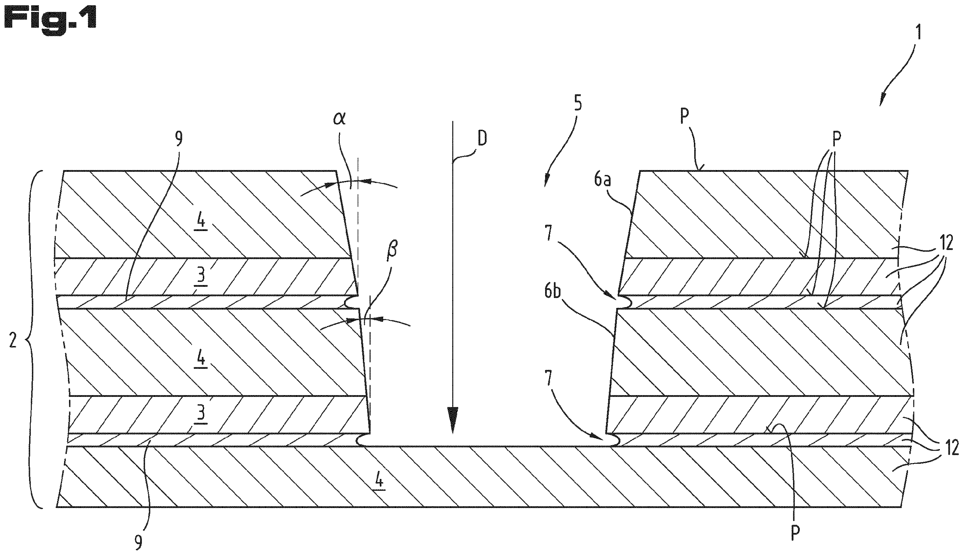

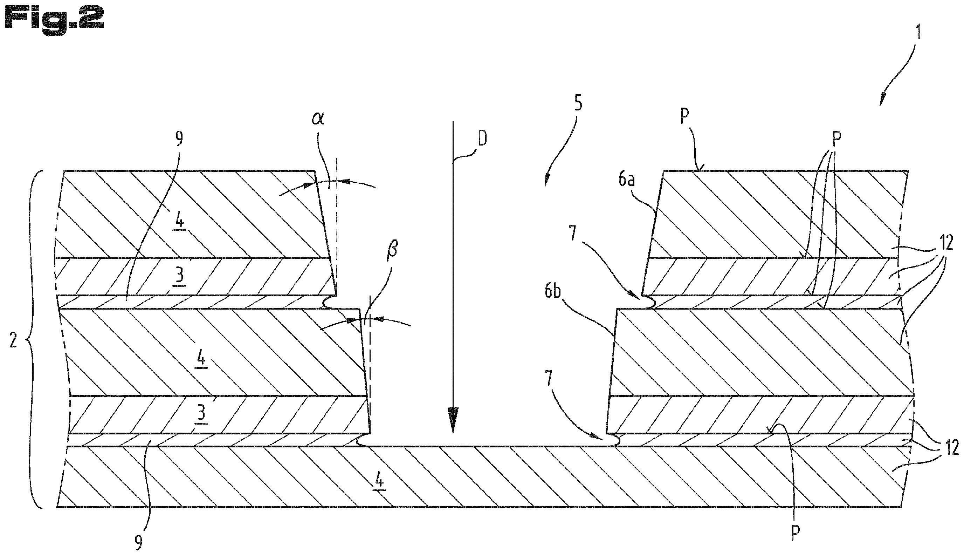

Fig. 1 and 2 show embodiments of a component carrier 1 comprising a stack 2 of a plurality of layers 12 forming at least one electrically conductive layer structure 3 and at least one electrically insulating layer structure 4. Said stack 2 comprising a - preferably conically shaped - cavity 5, wherein the cavity 5 extends - in the direction D perpendicular to the planes Pin which the layers 12 extend - through at least two layers 12 of the plurality of layers. The cavity 5 is delimited by a side wall 6, said side wall 6 being inclined with respect to the direction D perpendicular to the planes P of the layers 12. The corresponding inclination angle may be between 0,5° and 50°, preferably between 0,5° and 30°, more preferred between 1° and 15°. Additionally and/or alternatively, at least a portion of a side wall 6 may be perpendicular to the planes P (i.e. having no inclination).

In an example, the electrically conductive layer structure 3 may comprise copper, nickel, or tin. Additionally and/or alternatively, the electrically conductive layer structure 3 may comprise palladium, silver, gold, tungsten, chromium, or a combination thereof. In another example, the electrically conductive layer structure 3 may comprise carbon, for example graphene, or an electrically conductive polymer, for example Poly (3,4-ethylenedioxythiophene) (PEDOT). The electrically insulating layer structure 4, may comprise organic polymers for example, epoxy resin, cyanate ester resin, benzocyclobutene resin. Additionally and/or alternatively, the electrically insulating layer structure 4 may comprise inorganic material, for example glass in form of spheres, fibres or a plate like structure, or ceramic in form of spheres, fibres or a plate like structure. Moreover, the component carrier 1 may comprise a printed circuit board (PCB), an (IC) substrate or an interposer.

In the embodiments of Fig. 1 and 2, at least one, of the two recesses 7 (at different height levels) are provided in the side wall 6 of the cavity 5. The recess 7 locally disrupts the extension of the side wall and partially extending in the stack 2 along the planar extension of the stack 2.

It is preferred if the cavity 5 has - in the direction D perpendicular to the planes P in which the layers 12 extend - an extension of at least 200 µm, preferably at least 400 µm, more preferred at least 600 µm. Alternatively, the extension of the cavity 5 in the direction D perpendicular to the planes P may be in the range from 50 µm to 200 µm. It is further preferred if the cavity 5 has - in a direction parallel to the planes P in which the layers 12 extend - a width of at least 300 µm, preferably at least 1500 µm, more preferred at least 2000 µm. Alternatively, the extension of the cavity 5 in the direction parallel to the planes P may be in the range from 70 µm to 300 µm.

The recess 7 may have - in the direction D perpendicular to the planes P in which the layers 12 extend - an extension between 2 µm and 350 µm, preferably between 5 µm and 250 µm. The recess 7 may circumferentially around the cavity 5. It is preferred if a recess 7 is arranged at a level that is distanced from the bottom of the cavity by 30% to 70%, preferably 40% to 60%, of the height of the cavity 5. In the embodiments of Fig. 1 and 2 the recess is arranged at the middle height of the cavity 5. Another recess 7 is arranged in the region of the bottom of the cavity 5. In an example, at least a portion of at least one recess 7 may have a concave shape. Alternatively, at least another portion of the at least one recess 7 may have a convex shape. The shape of the recess 7 may have an impact on the mechanical stability of the recess and therefor may enable the formation of cavities having an extension perpendicular to the planes larger than 300 µm, in particular 400 µm.

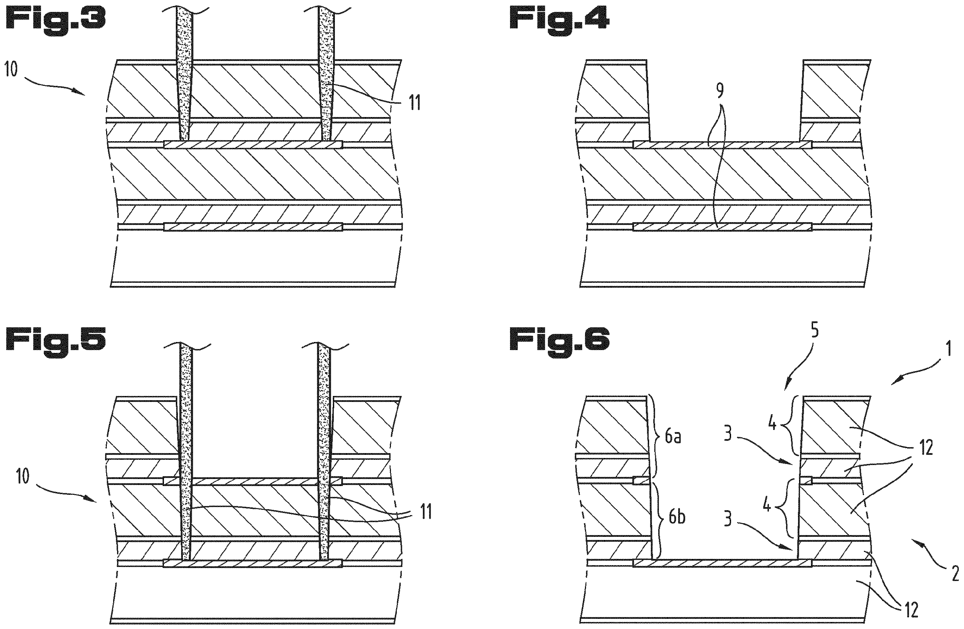

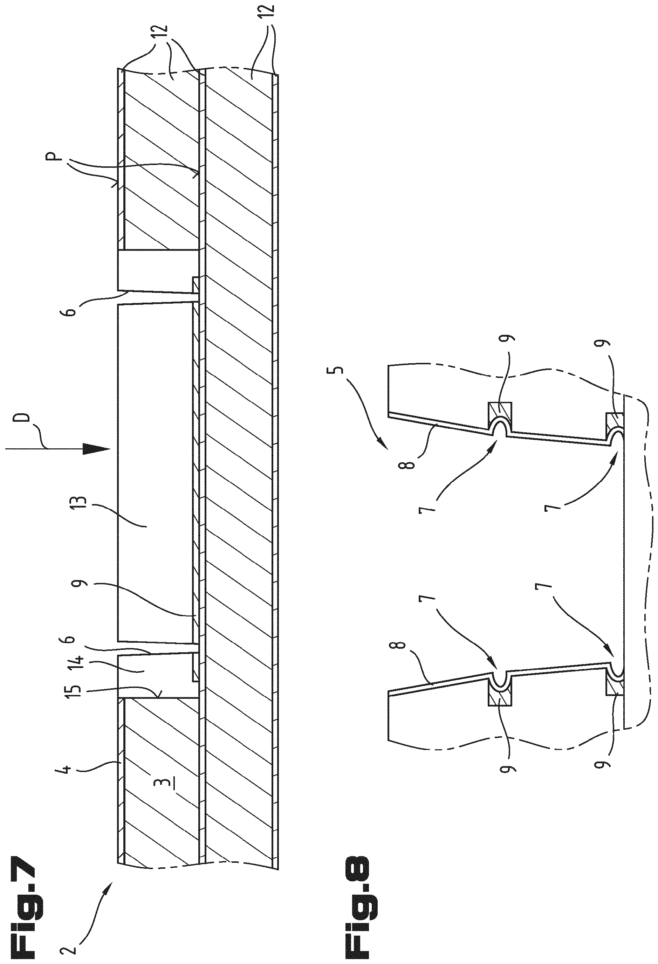

In the following - and prior to discuss further embodiments of the component carrier - the method for manufacturing a component carrier 1 will be described with the aid of figs. 3 to 6. The method comprises at least the steps:
(a) providing a stack 2 of a plurality of layers 12 forming at least one electrically conductive layer structure 3 and at least one electrically insulating layer structure 4, said stack 2 also comprising at least one release layer 9 at least partially extending within the stack 2, and
(b) forming a cavity 5 within said stack 2 by removing material, preferably material of at least two layers of the plurality of layers 12 (see embodiment of figs 3 to 6) or plugging material 13 locally replacing layers of the plurality of layers 12 (see embodiment of fig. 7), along a direction D transverse, preferably perpendicular, to the planes P in which the layers 12 extend, up to the release layer 9, such that the cavity 5 is delimited by a side wall 6, said side wall 6 being inclined with respect to the direction D perpendicular to the planes P of the layers 12,
(c) removing at least a portion of the release layer 9, such that at least one recess 7 is formed in the side wall 6 of said cavity 5, said recess 7 locally disrupting the side wall extension.

As can be seen from figs. 1 and 2 the release layer(s) 9 is/are depicted as an entire layer (i.e. extending throughout a large portion or even the entire of the component carrier 1). However, in an alternative preferred embodiment, the release layer(s) 9 extend only locally in the region where the cavity will be created (see fig. 3 to 6).

Step (b), i.e. forming a cavity, may be done by means of at least one laser, such as a CO₂ laser or an UV laser or an UV-CO₂ laser. For example, Red Light Lasers or Green Light (UV) Lasers can be used (e.g. with wavelengths of 532 nm and/or 515 nm and e.g. a power of 2-20 Watt).

It is preferred if step (b) is performed by laser cutting 10 along the contour of the resulting side wall 6. As indicated in Fig. 3 a focussed laser beam 11 is used to make a circumferential cut defining the side walls 6 of the resulting cavity 5.

In the special embodiment shown in figs. 3 to 6 step (b) comprises the sub-steps of:
(b1) removing material of a first portion of the stack 2 up to a first depth. The first depth may be defined by an intermediate (first) release layer 9 that is embedded within the stack 2 (the release layer 9 may be e.g. located on top of an electrically insulating layer structure or on top of an electrically conductive layer structure).
(b2) subsequent to step (b1): removing material of a second portion of the stack 2 up to a second depth. The second depth may be defined by a further (second) release layer 9 that is embedded within the stack 2 (also the further release layer 9 may be located e.g. on top of an electrically insulating layer structure or on top of an electrically conductive layer structure). The further release layer 9 may form the bottom release layer defining the overall depth of the cavity 5.

In a preferred embodiment, the laser stops its operation during step (b) if beneath the release layer 9 an electrically conductive layer is located, since the laser beam may be reflected and the laser tool recognizes that reflection.

Sub-steps (b1) and (b2) may be performed by laser cutting 10, wherein the geometry of the laser beam 11 used for sub-step (b1) differs from the geometry of the laser beam 11 used for sub-step (b2). It is preferred if the focus of the laser beam 11 is - preferably automatically - adjusted between the sub-step (b1) and the sub-step (b2). The laser beam 11 may be focused on the top layer of the stack 2 for sub-step (b1) and focused on the first depth for sub-step (b2). The first depth corresponds to the level of the intermediate (first) release layer 9.

Step (c) - i.e. the forming of the recess 7 - may be performed by at least partially removing material of a release layer 9 with a solvent.

A further embodiment of the component carrier 1 is characterized in that said recess 7 comprises residues of a material (of the release layer 9), preferably said material being different from the material(s) forming said side wall 6 of the cavity 5, wherein preferably the residues of the material is free from filler material.

In another embodiment said recess 7 is at least partially filled with a material, preferably said material being different from one of the material(s) forming said side wall 6 of the cavity 5.

In a very preferred embodiment shown in Fig. 8, said recess 7 is at least partially filled with an electrically conductive material 8, wherein preferably the side wall 6 is at least partially, preferably completely, covered by the electrically conductive material 8. As already mentioned at the beginning, a cavity shielded by an electrically conductive material, such as copper coated sidewalls, may be used as a waveguide for RF applications. The recess 7 may be used as mechanical and/or electrical connection to that shield.

Alternatively, said recess 7 may be at least partially filled with an electrically insulating material, wherein preferably said electrically insulating material is the same material that also covers at least partially, preferably completely, the side wall 6 of the cavity 5. Such an embodiment may be useful if for example the cavity 5 is used to direct cooling medium to a location within or near the stack 2.

As shown in the figs. 1 to 6 a recess of the at least one recess 7 may be located at the bottom extremity of the cavity 5. An intermediate recess of the at least one recess 7 may be located at the side wall 6 of the cavity 5 between the bottom extremity of the cavity 5 and the top extremity of the cavity 5.

The side wall 6 of the cavity 5 may be divided by said intermediate recess 7 in two side wall portions 6a, 6b. In fig. 1 and 2 it is indicated that the two side wall portions 6a, 6b are each inclined with respect to the direction D perpendicular to the planes P of the layers 12, preferably by an inclination angle α, β between 0,5° and 50°, preferably between 0,5° and 30°, more preferably between 1° and 15°.

The inclination angle α of the first 6a of the two side wall portions 6a, 6b may be different to, preferably greater than, the inclination angle β of the second 6b of the two side wall portions 6a, 6b. As already mentioned above, such a geometric constellation may be achieved by the sub-steps (b1) and (b2) using different geometric shapes (different focusses) of the laser beam 11 during laser cutting 10. The difference between the inclination angle α of the first 6a of the two side wall portions 6a, 6b and the inclination angle β of the second 6b of the two side wall portions 6a, 6b is between 0,5° and 10°.

The different inclination angles are direct consequence of splitting the process into sub-steps (b1) and (b2). Such a process may include multiple release layers, where the first cavity portion will be cut with a laser beam up to the first release layer. After that the cut-out (cap) will be removed. Then the release layer below the removed cap will be used as the new registration/focus layer. A tool in laser programming can focus on a new height level to reduce the laser beam loss. With this new focus of the laser beam the second stage can be a smoother laser cut. The first and second laser cut can be distinguished, for example by the intermediate recess 7, in the final product.

Fig. 2 shows an embodiment according to which one 6b of the two side wall portions 6a, 6b is offset to the other 6a of the two side wall portions 6a, 6b in a direction parallel to the planes P of the layers 12. One can still see the recesses 7 in the middle region and the bottom region. As already mentioned previously, the offset provided within a first (e.g. the left) side wall may be different to the offset provided in a second (e.g. the right) side wall opposite to the first side wall.

The at least one recess 7 - in the direction D perpendicular to the planes P in which the layers 12 extend - may be at least partially delimited by an electrically insulating layer structure 4.

Fig. 7 shows a further embodiment of a component carrier. Here, at least two layers of the plurality of layers 12 are interrupted by a recess-aperture 15 and a ring-shaped element 14 is provided in said recess-aperture 15, said ring-shaped element 14 defining with its opening the cavity 5. The material of the ring-shaped element 14 maybe different from the materials of the plurality of layers 12 and/or may have a homogeneous structure. Such an embodiment may be achieved if plugging material 13 locally replaces layers of the plurality of layers 12. The cut is performed within that plugging material 13 (see fig. 7) and the central part of the plugging material 13 is removed. The remaining part of the plugging material 13 - i.e. the ring-shaped element 14 - then forms the side walls 6 of the cavity 5.

Alternatively, the ring-shaped element 14 may comprise a heterogeneous structure comprising filler material, for example, inorganic particles (glass, ceramic, carbon, pigments).

The invention, of course, also relates to a component carrier assembly comprising a component carrier 1 according to one of the preceding claims, and at least one electronic component mounted to the component carrier 1. The electronic component may be at least partially embedded within the component carrier 1, preferably within the cavity 5 or adjacent to the cavity 5. The electronic component may be a (e.g. RF) transducer for emitting and/or receiving (e.g. RF) radiation running through the cavity 5.

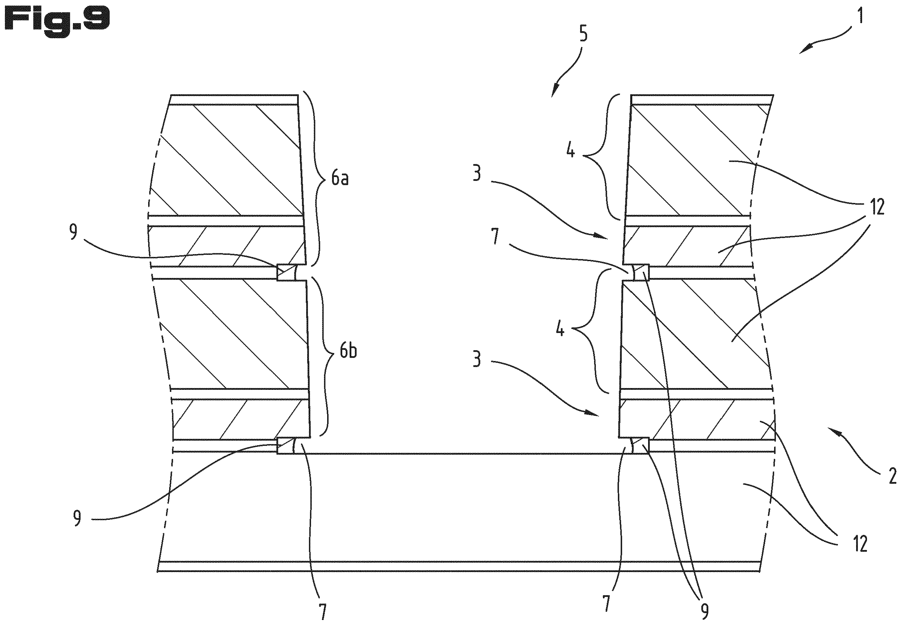

As can be seen e.g. from the figs. 8 and 9 a portion of the original release layer 9 may still be present in the manufactured component carrier, e.g. between the electrically insulating layer structure 4 and the electrically conductive layer structure 3, in the final product. The term "original release layer" is understood as the release layer that is provided within the initial stack, but that has been partly removed by the process.

### List of references

- 1: component carrier
- 2: stack
- 3: electrically conductive layer structure
- 4: electrically insulating layer structure
- 5: cavity
- 6: side wall
- 6a: first side wall portion
- 6b: second side wall portion
- 7: recess
- 8: electrically conductive material
- 9: release layer
- 10: laser cutting
- 11: laser beam
- 12: layers
- 13: plugging material
- 14: ring-shaped element
- 15: recess-aperture
- α: inclination angle of the first side wall portion 6a
- β: inclination angle of the second side wall portion 6b
- D: direction perpendicular to the planes P in which the layers 12 extend
- P: planes in which the layers 12 extend

## Claims

1. A component carrier (1) comprising a stack (2) of a plurality of layers (12) forming at least one electrically conductive layer structure (3) and at least one electrically insulating layer structure (4), said stack (2) comprising a - preferably conically shaped - cavity (5), wherein the cavity (5) extends - in the direction (D) perpendicular to the planes (P) in which the layers (12) extend - through at least two layers (12) of the plurality of layers, said cavity (5) being delimited by a side wall (6), said side wall (6) being inclined with respect to the direction (D) perpendicular to the planes (P) of the layers (12), preferably by an inclination angle between 0,5° and 50°, preferably between 0,5° and 30°, more preferably between 1° and 15°, wherein at least one recess (7) is provided in the side wall (6) of said cavity (5), said recess (7) locally disrupting the side wall extension and partially extending in the stack (2) along the planar extension of the stack (2).

2. A component carrier according to claim 1, wherein the cavity (5) has - in the direction (D) perpendicular to the planes (P) in which the layers (12) extend - an extension of at least 200 µm, preferably at least 400 µm, more preferred at least 600 µm,
and/or wherein the cavity (5) has - in a direction parallel to the planes (P) in which the layers (12) extend - a width of at least 300 µm, preferably at least 1500 µm, more preferred at least 2000 µm.

3. A component carrier according to claim 1 or 2, wherein said recess (7) has - in the direction (D) perpendicular to the planes (P) in which the layers (12) extend - an extension between 2 µm and 350 µm, preferably between 5 µm and 250 µm, and/or wherein said recess (7) runs circumferentially around the cavity (5) and/or wherein said recess (7) is arranged at a level that is distanced from the bottom of the cavity by 30% to 70%, preferably 40% to 60%, of the height of the cavity (5) or is arranged in the region of the bottom of the cavity (5).

4. A component carrier according to one of the preceding claims, wherein said recess (7) comprises residues of a material, preferably said material being different from the material(s) forming said side wall (6) of the cavity (5), wherein preferably the residues of the material is free from filler material.

5. A component carrier according to one of the preceding claims, wherein said recess (7) is at least partially filled with a material, preferably said material being different from one of the material(s) forming said side wall (6) of the cavity (5),
and/or wherein said recess (7) is at least partially filled with an electrically conductive material (8), wherein preferably the side wall (6) of the cavity (5) is at least partially, preferably completely, covered by the electrically conductive material (8),
and/or wherein said recess (7) is at least partially filled with an electrically insulating material, wherein preferably said electrically insulating material is the same material that also covers at least partially, preferably completely, the side wall (6) of the cavity (5).

6. A component carrier according to one of the preceding claims, wherein a recess of the at least one recess (7) is located at the bottom extremity of the cavity (5)
and/or wherein an intermediate recess of the at least one recess (7) is located at the side wall (6) of the cavity (5) between the bottom extremity of the cavity (5) and the top extremity of the cavity (5).

7. A component carrier according to one of the preceding claims, wherein the at least one recess (7) - in the direction (D) perpendicular to the planes (P) in which the layers (12) extend - is at least partially delimited by an electrically insulating layer structure (4).

8. A component carrier according to one of the preceding claims, wherein the side wall (6) of the cavity (5) is divided by said intermediate recess (7) in two side wall portions (6a, 6b).

9. A component carrier according to one of the preceding claims, wherein the two side wall portions (6a, 6b) are each inclined with respect to the direction (D) perpendicular to the planes (P) of the layers (12), preferably by an inclination angle (α, β) between 0,5° and 50°, preferably between 0,5° and 30°, more preferably between 1° and 15°, wherein preferably the inclination angle (α) of the first (6a) of the two side wall portions (6a, 6b) is different to, preferably greater than, the inclination angle (β) of the second (6b) of the two side wall portions (6a, 6b), wherein preferably the difference between the inclination angle (α) of the first (6a) of the two side wall portions (6a, 6b) and the inclination angle (β) of the second (6b) of the two side wall portions (6a, 6b) is between 0,5° and 10°.

10. A component carrier according to claim 8 or 9, wherein one (6b) of the two side wall portions (6a, 6b) is offset to the other (6a) of the two side wall portions (6a, 6b) in a direction parallel to the planes (P) of the layers (12).

11. A component carrier according to one of the preceding claims, wherein at least two layers of the plurality of layers (12) are interrupted by a recess-aperture (15) and a ring-shaped element (14) is provided in said recess-aperture (15), said ring-shaped element (14) defining with its opening the cavity (5), wherein preferably the material of the ring-shaped element (14) is different from the materials of the plurality of layers (12) and/or has a homogeneous structure.

12. A component carrier assembly comprising a component carrier (1) according to one of the preceding claims, and at least one electronic component mounted to the component carrier (1), wherein preferably the electronic component is at least partially embedded within the component carrier, preferably within the cavity (5) or adjacent to the cavity (5), wherein preferably the electronic component is a transducer for emitting and/or receiving radiation running through the cavity (5).

13. A method for manufacturing a component carrier (1), preferably according to one of the preceding claims, the method comprising the steps of:
(a) providing a stack (2) of a plurality of layers (12) forming at least one electrically conductive layer structure (3) and at least one electrically insulating layer structure (4), said stack (2) also comprising at least one release layer (9) at least partially extending within the stack (2), and
(b) forming a cavity (5) within said stack (2) by removing material, preferably material of at least two layers (12) of the plurality of layers or plugging material (13) locally replacing layers of the plurality of layers (12), along a direction transverse, preferably perpendicular, to the planes (P) in which the layers (12) extend, up to the release layer (9), such that the cavity (5) is delimited by a side wall (6), said side wall (6) being inclined with respect to the direction (D) perpendicular to the planes (P) of the layers (12),
(c) removing at least a portion of the release layer (9), such that at least one recess (7) is formed in the side wall (6) of said cavity (5), said recess (7) locally disrupting the side wall extension.

14. A method according to claim 13, wherein step (b) is performed by laser cutting (10) along the contour of the resulting side wall (6) and/or wherein step (c) is performed by at least partially removing material of a release layer (9) with a solvent.

15. A method according to claim 13 or 14, wherein step (b) comprises the sub-steps of:
(b1) removing material of a first portion of the stack (2) up to a first depth, wherein preferably the first depth is defined by an intermediate release layer (9), and
(b2) subsequent to step (b1) removing material of a second portion of the stack (2) up to a second depth, wherein preferably the second depth is defined by a further release layer (9), preferably a bottom release layer,
wherein preferably sub-steps (b1) and (b2) are performed by laser cutting (10), wherein the geometry of the laser beam (11) used for sub-step (b1) differs from the geometry of the laser beam (11) used for sub-step (b2), wherein preferably the focus of the laser beam (11) is - preferably automatically - adjusted between the sub-steps (b1) and (b2), wherein preferably the laser beam (11) is focused on the top layer of the stack (2) for sub-step (b1) and focused on the first depth for sub-step (b2).
